# EUROPEAN PATENT APPLICATION

(11) **EP 4 057 459 A1**
(43) Date of publication of application: **14.09.2022**
(21) Application number: 21305311.9
(22) Date of filing: 12.03.2021
(51) Int. Cl.: H02G 3/04, H02G 3/08, H02G 3/18, H02G 3/22, H02G 15/013, H02G 15/117, A62C 2/06, F16L 5/04, H02G 1/06, H05K 5/06

(54) **DIAMETER ADAPTIVE (THREAD AND TOOLLESS) SEALING**

(71) Applicant: Nexans, 92400 Courbevoie (FR)
(72) Inventor: ANDERSSON, Per-Erik, 51434 Tranemo (SE)
(74) Representative: Ipsilon

(57) **Abstract**

The present invention relates to a cable feedthrough (1) for guiding a cable (CA) from a first side (S1) of a sealing plane (SP) to a second side (S2) of the sealing plane (SP). The cable feedthrough (1) comprises a first compressible sealing body (10) extending on both sides (S1, S2) of the sealing plane (SP) and a second compressible sealing body (20) extending on both sides (S1, S2) of the sealing plane (SP) and provided abutting the first compressible sealing body (10). The cable feedthrough further comprises a compressing device (60) for compressing the first compressible sealing body (10) and the second compressible sealing body (20) towards each other. The first compressible sealing body (10) comprises a first V-shaped or U-shaped cutout (12) on the first side (S1) of the sealing plane (SP). The second compressible sealing body (20) comprises a second V-shaped or U-shaped cutout (22) on the second side (S2) of the sealing plane (SP). The first cutout (12) and the second cutout (22) are defining a cable axis (LCA) for the cable (CA).

## Description

### FIELD OF THE INVENTION

The present invention relates to a cable feedthrough for guiding a cable from a first side of a sealing plane to a second side of the sealing plane. The present invention also relates to a method for guiding a cable from a first side of a sealing plane to a second side of the sealing plane.

### BACKGROUND OF THE INVENTION

A cable feedthrough is used when energy and/or a communication signal carried by a cable is transferred from a first side of a barrier to a second side of the barrier. Typically, the cable feedthrough is used to prevent water, moisture, dust or other particles from being transferred from the first side to the second side of the barrier. In addition, the cable feedthrough may prevent heat from being transferred between the first side and the second side of the barrier. In addition, the cable feedthrough may have gas sealing properties and/or fire prevention properties.

One type of cable feedthrough comprises cable connectors, where a first cable section on the first side of the barrier is connected to a second cable section on the second side of the barrier.

Another type of cable feedthrough comprises sealing elements, where the cable is guided from the first side of the barrier to the second side of the barrier and the sealing elements are sealingly engaged with the outer surface of the cable.

One example of the latter is disclosed in CH682784. Here, a dust- and water-proof cable feedthrough receives a number of cables to be passed through the wall of electrical equipment. Openings are provided in the upper and lower lids of the equipment housing for receiving four elastically deformable sealing strips and bored cylindrical spacers. The sealing strips positioned around the cables are made of a material which is harder than the sealing strips placed on the lids of the equipment housing. Screws are provided to press the upper and lower lids together.

One object of the present invention is to provide a cable feedthrough which are adapted to a range of different cable diameters.

One further object of the present invention is to provide a cable feedthrough which is easy to install.

### SUMMARY OF THE INVENTION

The present invention relates to a cable feedthrough for guiding a cable from a first side of a sealing plane to a second side of the sealing plane, wherein the cable feedthrough comprises:
- a first compressible sealing body extending on both sides of the sealing plane;
- a second compressible sealing body extending on both sides of the sealing plane and provided abutting the first compressible sealing body;
- a compressing device for compressing the first compressible sealing body and the second compressible sealing body towards each other;
wherein the first compressible sealing body comprises a first V-shaped or U-shaped cutout on the first side of the sealing plane;
wherein the second compressible sealing body comprises a second V-shaped or U-shaped cutout on the second side of the sealing plane;
wherein the first cutout and the second cutout are defining a cable axis for the cable.

The term "U-shape" is here referring to a shape which cross sectional area is resembling the capital letter U. The term "V-shape" is here referring to a shape which cross sectional area is resembling the capital letter V.

The term "cable" is here referring to a communication cable, an electric cable etc. The communication cable may comprise electric communication conductors, optic fibers etc. The electric cable may comprise one or a plurality of electric conductors. The cable may have a substantially circular cross sectional shape, or it may have a different cross sectional shape.

The term "cutout" is here referring to a shape. It should be noted that the term "cutout" is not referring to a manufacturing method. In one manufacturing method for manufacturing the first compressible sealing body and the second compressible sealing body, the V-shaped or U-shaped cutouts may be achieved by removing parts of an original body shaped as a rectangular prism. However, the same result may be achieved by additive manufacturing methods.

In one aspect, the cable axis is substantially perpendicular to the sealing plane.

In one aspect, an apex or narrow end of the first cutout is provided at a distance from an apex or a narrow end of the second cutout.

According to the distance between the narrow end of the first cutout and the narrow end of the second cutout, an overlapping area is provided across the sealing plane, in which there are no cutouts. In this overlapping area, sealing between the first compressible sealing body and the second compressible sealing body is achieved also in situations where no cable is present.

Preferably, the overlapping area is oriented substantially perpendicular to the sealing plane.

In one aspect, the V-shape or U-shape of the cutouts are defined as the shape of the cutouts in a plane substantially perpendicular to the sealing plane.

In one aspect, an apex or a narrow end of the respective cutouts is proximal relative to the sealing plane and a wider end of the V-shaped or U-shaped cutouts is distal relative to the sealing plane.

In one aspect, the V-shape or U-shape cutouts are V-shaped or U-shaped also in a plane parallel to the sealing plane. In this parallel plane to the sealing plane, an apex or a narrow end of the respective cutouts is distal relative to the cable axis and a wider end is proximal relative to the cable axis.

In one aspect, the cable feedthrough comprises a guide for guiding the bodies during compression.

According to the guide, it is achieved that the first compressible sealing body is aligned with the second compressible sealing body during and after compression.

In one aspect, the first compressible sealing body comprises a first groove engaged with the guide and wherein the second compressible sealing body comprises a second groove engaged with the guide.

In one aspect, the compressing device comprises a fastener adjustably connected to the guide.

In one aspect, the guide comprises several apertures, and the fastener comprises a protruding element received in one of the apertures of the guide. Hence, the degree of compression can be adjusted by connecting the fastener to a different aperture of the guide.

In one aspect, each compressible sealing body comprises V-shaped or U-shaped cutouts on both the first side and the second side of the sealing plane.

In one aspect, the cable feedthrough comprises a strain relief protruding in the cable axis away from the sealing plane. The cable may be secured to the strain relief by means of strips. In one aspect, the strain relief is connected to the base. In one aspect, the strain relief is connected to the guides. In one aspect, the strain relief is connected to the compressing device.

In one aspect, the cable feedthrough comprises:
- a third compressible sealing body extending on both sides of the sealing plane and abutting the second compressible sealing body;
- a fourth compressible sealing body extending on both sides of the sealing plane and abutting the third compressible sealing body;
wherein the third compressible sealing body comprises a third V-shaped or U-shaped cutout provided on either the first side or the second side;
wherein the fourth compressible sealing body comprises a fourth V-shaped or U-shaped cutout on the opposite side of the third cutout;
wherein the third cutout and the fourth cutout are defining a further cable axis for a further cable;
wherein the third compressible sealing body and the forth compressible sealing body are compressed towards each other by means of the compressing device.

In one aspect, the cable feedthrough comprises:
- a separation element provided between the second compressible sealing body and the third compressible sealing body.

In one aspect, the strain relief is protruding from the separation element.

In one aspect, the separation element is separating the cable axis between the first and second compressible sealing bodies from the cable axis between the third and fourth compressible sealing bodies. In one aspect, the separation element is a rigid element.

In one aspect, each sealing body may comprise several cutouts, each cutout defining a cable axis for a cable. Several cables may be therefore be guided in parallel to each other and spaced apart from each other through the sealing plane. Due to the shape of the cutout, the compressed sealing bodies will adapt to the different cable shapes and different cable diameters and sealingly engage the outer surface of the cables.

The present invention also relates to a method for guiding a cable from a first side of a sealing plane to a second side of the sealing plane, comprising the steps of:
- providing a first compressible sealing body on both sides of the sealing plane, wherein the first compressible sealing body comprises a first V-shaped or U-shaped cutout on the first side of the sealing plane;
- providing a second compressible sealing body on both sides of the sealing plane; wherein the second compressible sealing body comprises a second V-shaped or U-shaped cutout on the second side of the sealing plane;
- placing the cable between the first compressible sealing body and the second compressible sealing body;
- aligning the cable with the first and second cutouts;
- compressing the first compressible sealing body and the second compressible sealing body towards each other.

In one aspect, the method further comprises the step of securing the first compressible sealing body and the second compressible sealing body in their compressed state.

In one aspect, the method further comprises the step of:
- securing the cable to a strain relief.

In one aspect, the method further comprises the step of:
- applying a sealing agent to the outside of the cable being in contact with the first compressible sealing body and the second compressible sealing body.

According to the cutouts of the sealing elements, it is achieved that one cable feedthrough may be used for a range of different cable diameters. This makes the cable feedthrough flexible to use for several types of installations. By means of a few different sealing bodies, the cable feedthrough may be used for a wide range of different cable diameters.

According to some of the embodiments above, no tool is required during installation of the cable feedthrough, making the installation easy and effective.

According to some of the embodiments above, access to an end of the cable is not needed for the purpose of threading the cable through an aperture of the cable feedthrough. Instead, the cable feedthrough may be mounted or retrofitted to the outside of the cable.

### DETAILED DESCRIPTION

Embodiments of the invention will now be described with reference to the enclosed drawings, wherein:
Fig. 1 illustrates a perspective view of a first embodiment of the cable feedthrough;
Fig. 2 illustrates a top view of the second compressible sealing body inserted between guides, where the position of the cutouts of the first compressible sealing body have been indicated;
Fig. 3 illustrates an exploded side view of a second embodiment of the cable feedthrough;
Fig. 4 illustrates the second embodiment of the cable feedthrough, where the different elements have been inserted between the guides;
Fig. 5 illustrates the second embodiment of the cable feedthrough, where the different elements have been compressed;
Fig. 6 illustrates an embodiment where the compressing device is secured to the guide;
Fig. 7a-f illustrates different embodiments of cutouts;
Fig. 8a illustrates a perspective view of a further embodiment of the compressible sealing body;
Fig. 8b illustrates a perspective view of yet a further embodiment compressible sealing body;
Fig. 9a and 9b illustrate a perspective view of the cable feedthrough in fig. 6 in the uncompressed and compressed states respectively;
Fig. 10 illustrates an alternative embodiment where each compressible sealing body comprises cutouts on both sides of the sealing plane;
Fig. 11 illustrates a strain relief connected to the base.

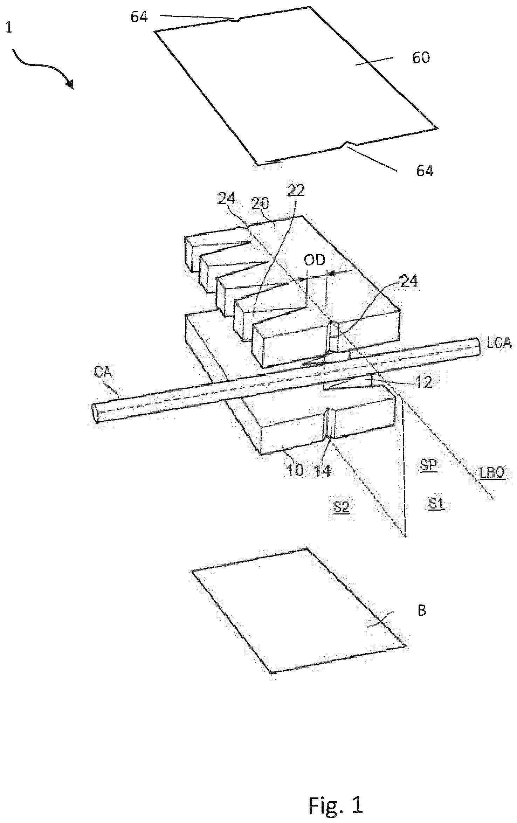

Initially, it is referred to fig. 1. Here, parts of a cable feedthrough 1 and a cable CA is shown. The purpose of the cable feedthrough 1 is to guide the cable CA from a first side S1 of a sealing plane SP to a second side S2 of the sealing plane SP. The sealing plane SP is indicated by dashed lines.

The cable CA is shown with a longitudinal cable axis LCA indicated by a dashed line perpendicular to the sealing plane SP.

The main object of the cable feedthrough 1 is to prevent water droplets, moisture, dust or other particles from being transferred between the first side S1 and the second side S2. A further object may be to prevent heat from being transferred between the first side S1 and the second side S2.

The cable feedthrough 1 further comprises a first compressible sealing body 10 and a second compressible sealing body 20 extending on both sides S1, S2 of the sealing plane S1, S2.

The first compressible sealing body 10 will now be described in detail. The sealing body 10 is substantially shaped as a rectangular prism and is made of a compressible material. The compressible material may be a cell rubber etc.

The first compressible sealing body 10 comprises a number of V-shaped cutouts 12. In the present embodiments, the number of cutouts 12 in the first compressible sealing body 10 is four, i.e. identical to the number of V-shaped cutouts 22 provided in the second compressible sealing body 20.

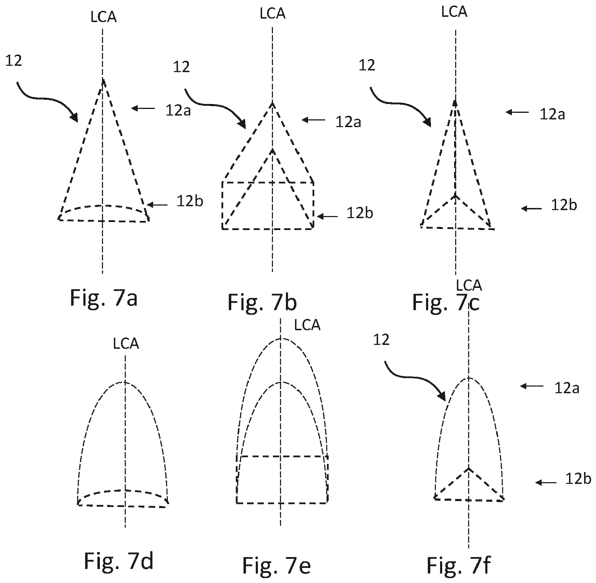

The V-shape of the cutout is here defined as the shape of the cutouts in a plane substantially perpendicular to the sealing plane SP. Hence, if the cutout is made by cutting away a section of a rectangular prism, the cutaway section will have a shape as shown in fig. 7b, i.e. as a triangular prism.

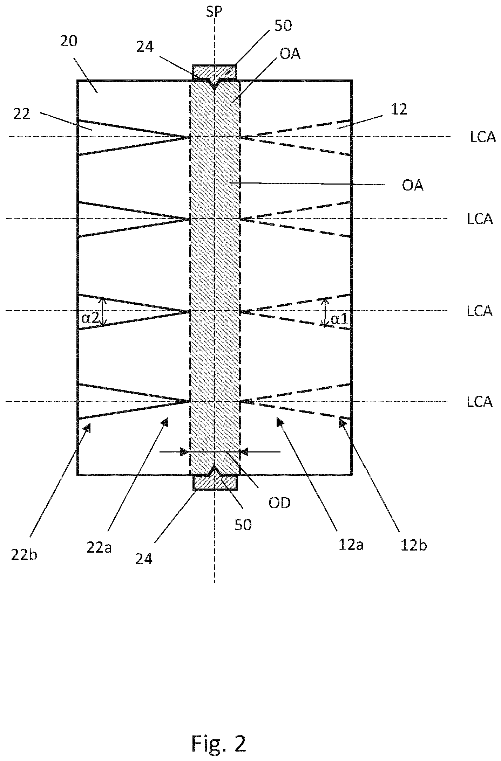

In fig. 1 and fig. 2 it is shown that an apex or a narrow end 12a of the cutout 12 is shown proximal to the sealing plane SP and a wider end 12b of the cutout is distal relative to the sealing plane SP. It should further be noted that there is a distance between the apex or narrow end 12a of the cutout 12 to the sealing plane SP. This distance will be further described in detail below with reference to fig. 2.

The angle between the legs of the V-shaped cutout 12 is indicated as a first angle α1, which in fig. 2 is shown to be ca 25°. It should be noted that the first angle α1 preferably is in the interval of 10° - 60°, even more preferred 20° - 35°.

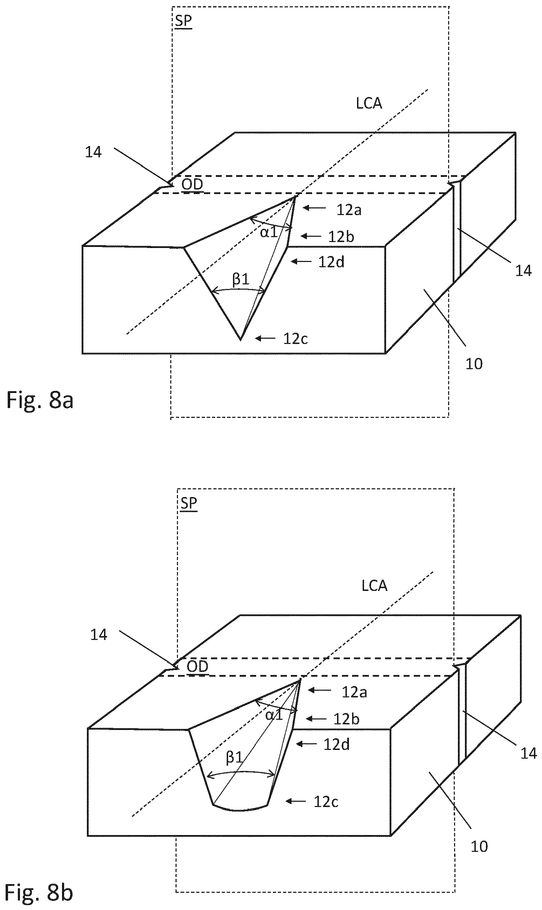

In fig. 1, it is also shown that the first compressible sealing body 10 comprises a first groove 14. As best shown in the embodiment in fig. 8a, there are two such grooves 14. The grooves 14 are aligned with the sealing plane SP.

The second compressible sealing body 20 will now be described in detail. It should be noted that the second compressible sealing body 20 in the present embodiment is identical to the first compressible sealing body 10.

As described above, the second compressible sealing body 20 comprises four V-shaped cutouts 22. In fig. 2, the second cutout 22 is shown with a second angle α2 equal to the first angle α1.

In fig. 1, it is also shown that the second compressible sealing body 20 comprises a second groove 24. As best shown in fig. 2, there are two such grooves 24. The grooves 24 are aligned with the sealing plane SP.

It should be noted that even though the first compressible sealing body 10 and the second compressible sealing body 20 are identical to each other, they are oriented differently with respect to the sealing plane SP. In fig. 1 and fig. 2, the cutouts 12 of the first compressible sealing body 10 is located on the first side S1 of the sealing plane SP, while the cutouts 22 of the second compressible sealing body 20 is located on the second side S2 of the sealing plane SP. As shown in fig. 2, the cutouts 12, 22 are arranged in pairs of one cutout 12 on the first side S1 and one cutout 22 on the second side S2. Each pair of cutouts 12, 22 is defining a cable axis LCA for a cable CA. Hence, four cables CA can be guided through the sealing plane SP by means of the cable feedthrough 1 of fig. 1 and 2.

Above, it was described that there is a distance between the apex or narrow end 12a of the cutout 12 to the sealing plane SP. Similarly, there is a distance between the apex or narrow end 22a of the cutout 22 to the sealing plane SP. These sum of these two distances are indicated in fig. 2 as an overlapping distance OD. The overlapping distance OD in the direction of the sealing plane SP is indicated as hatched area referred to as an overlapping area OA. The primary purpose of the overlapping area OA is to achieve that the cable feedthrough is forming a barrier when less than four cables are guided through the sealing plane SP.

It is now referred to fig. 1 again. Here it is shown that the cable feedthrough 1 further comprises a compressing device 60 for compressing the first compressible sealing body 10 and the second compressible sealing body 20 towards each other. The compression device 60 may comprises two grooves 64, similar to the grooves 14, 24 of the sealing bodies 10, 20. When the first compressible sealing body 10 and the second compressible sealing body 20 are compressed towards each other, they will sealingly engage the outer surface of the cable CA. This will be described further in detail below.

A base B is also shown in fig. 1. The compressing device 60 is moved towards the base B for compressing the first compressible sealing body 10 and the second compressible sealing body 20 towards each other. The base B may in some embodiments be a part of the cable feedthrough - in other embodiments, the base B is a part of the barrier in which the cable feedthrough 1 is mounted.

It is now referred to fig. 2. Here it is shown that the cable feedthrough 1 further comprises a guide 50. In the present embodiment, there are two guides 50, each guide 50 engaged with the first grooves 14 of the first sealing body 10 and the second grooves 24 of the second sealing body 20. The sealing bodies 10, 20 and the compressing device 60 are axially displaceable between the guides 50. During the axial displacement, the sealing bodies 10, 20 and the compressing device 60 are oriented correctly with respect to each other due to the grooves 14, 24, 64 being engaged with the guides 50.

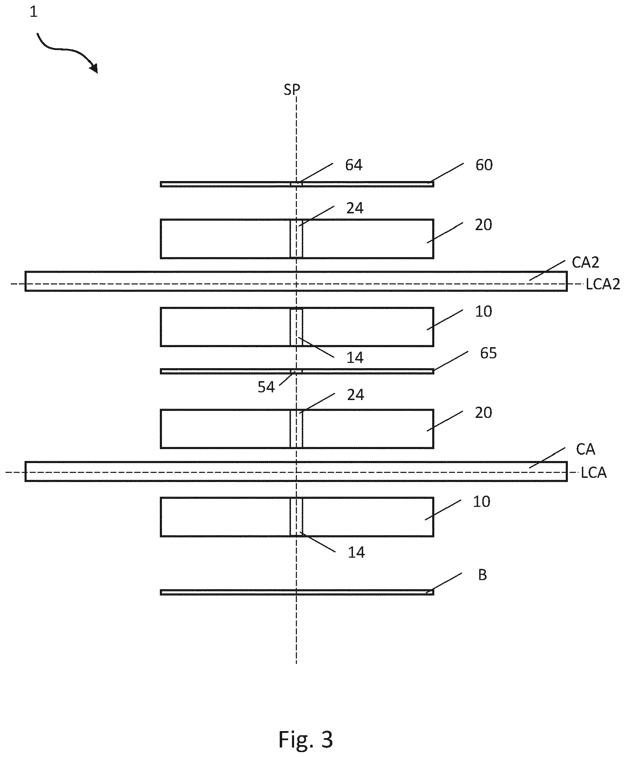

It is now referred to fig. 3, showing a further embodiment. Here, the cable feedthrough 1 comprises a third compressible sealing body 30 and a fourth compressible sealing body 40, both identical to the first and second sealing bodies 10, 20.

Cutouts 32 of the third compressible sealing body 30 are located on the first side of the sealing plane SP, while cutouts 42 of the fourth compressible sealing body 40 are located on the second side of the sealing plane SP. The third and fourth compressible sealing bodies 30, 40 both comprises third and fourth grooves 34, 44 for engaging the guides 50.

The cable feedthrough 1 may further comprises a separation element 65 provided between the second compressible sealing body 20 and the third compressible sealing body 30. The separation element 65 is relatively rigid compared with the compressible sealing bodies to ensure that compression of the sealing bodies is more or less evenly distributed. The separation element 65 may be a plate spring, or another type of metal or plastic plate.

In this embodiment, cables CA can be guided from the first side S1 to the second side S2 in two different layers, one layer indicated as cable axis LCA between the first and second sealing bodies 10, 20 and one further layer indicated as cable axis LCA2 between the third and fourth sealing bodies 30, 40.

### The assembly of the cable feedthrough 1

The assembly of the cable feedthrough 1 will now be described with reference to fig. 3 - 6. This assembly operation is the method used for guiding the cable from the first side S1 of the sealing plane SP to the second side S2 of the sealing plane SP.

In the present embodiment, the guides 50 are secured to the base B, i.e. no relative movement between the base B and the guides 50 is possible.

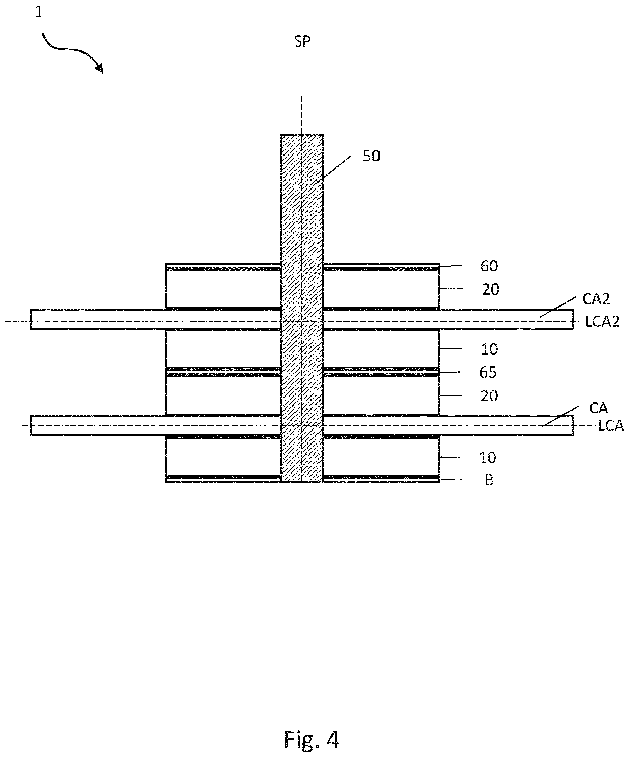

In fig. 4, it is shown that the different parts of the cable feedthrough 1 are inserted from the top of the guides 50 and are guided downwardly between the guides 50.

First, the first compressible sealing body 10 is inserted until it is abutting the base B.

Then the cable CA is oriented along the cable axis LCA defined by the first and second cutouts 12, 22. A sealing agent may be applying to the outside of the cable CA in the area of the cable being in contact with the sealing bodies, to further improve the sealing properties of the cable feedthrough 1. The sealing agent may be a petroleum jelly, a grease or other suitable sealing agents.

In the present embodiment, the cable axis LCA is perpendicular to the sealing plane SP, the sealing plane SP being easily observable for the person assembling the cable feedthrough 1 as a line between the two guides 50.

In a subsequent step, the second compressible sealing body 20 is inserted until it is abutting the cable CA and/or the first sealing body 10. An adjustment of the position of the cable CA with respect to the first and second cutouts 12, 22 are possible.

Then the separation plate 65 is inserted until it is abutting the second sealing body 20.

Then the third sealing body 30 is inserted until it is abutting the separation plate 65.

Then the further cable CA2 is oriented along the further cable axis LCA2 defined by the third and fourth cutouts 32, 42. Again, a sealing agent may be applying to the outside of the cable CA in the area of the cable being in contact with the sealing bodies, to further improve the sealing properties of the cable feedthrough 1.

Then, the fourth sealing body 40 is inserted until it is abutting the further cable CA2 and/or the third sealing body 10. Again, an adjustment of the position of the further cable CA2 is possible.

Then the compressing device 60 is insert until it is abutting the fourth sealing body 40.

The situation is now as shown in fig. 4.

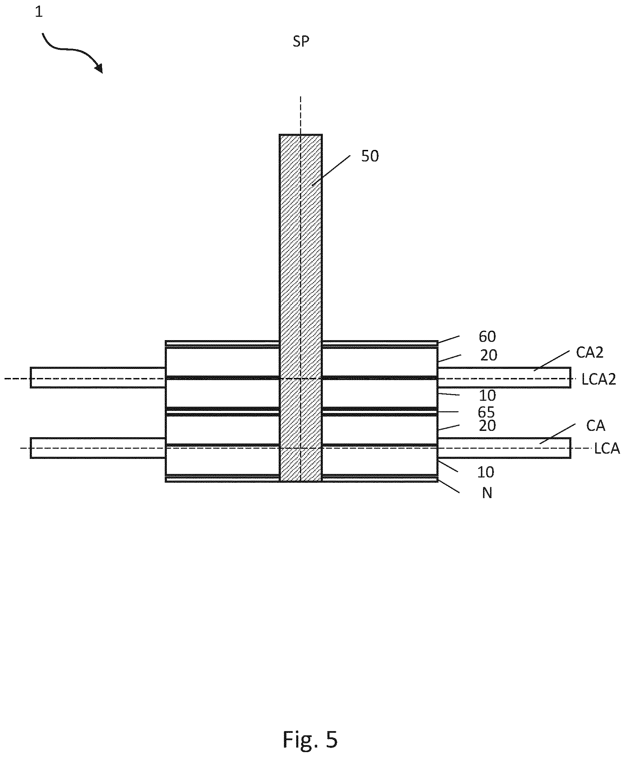

It is now referred to fig. 5. Here, the compressing device 60 is pushed downwardly towards the base B, thereby compressing the sealing bodies 10, 20, 30, 40 and thereby also causing them to move downwardly relative to the guides 50. This will cause the sealing bodies 10, 20, 30, 40 to be deformed and to seal against the outer surface of the respective cables CA, CA2.

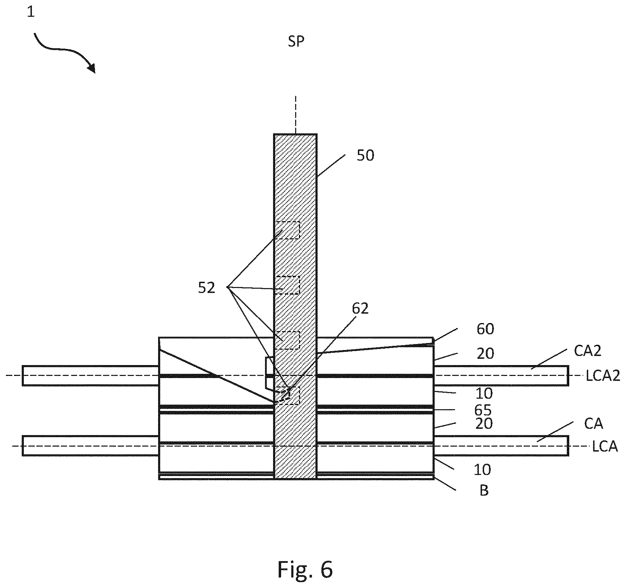

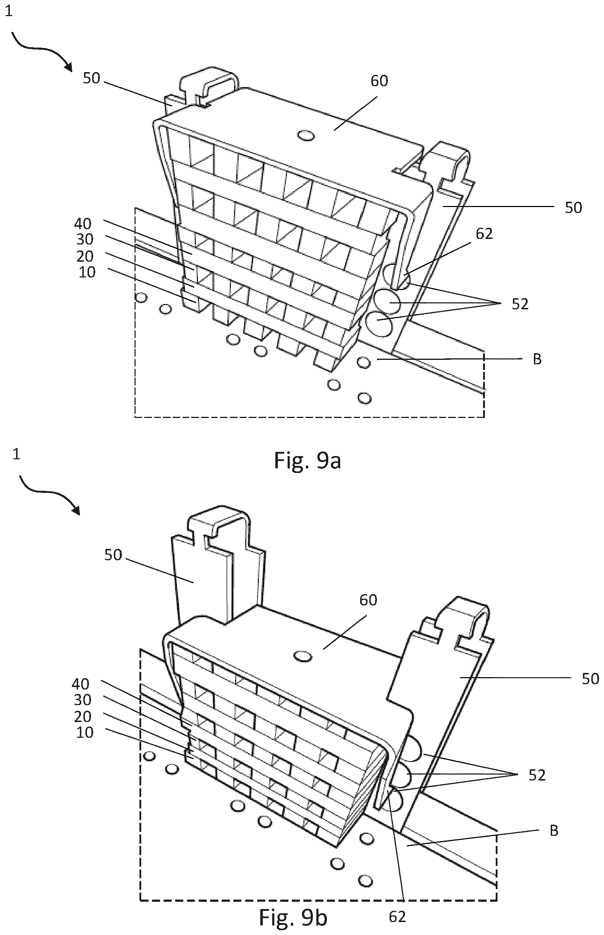

The compressing device 60 is now secured in the position shown in fig. 5. One way of doing this is showed in fig. 6, fig. 9a and fig. 9b, where the compressing device 60 comprises a fastener 62 for engaging an aperture 52 of the guide 50. The guide 50 may comprise several apertures 52 at different heights relative to the base B. Hence, the degree of compression can be adjusted by connecting the fastener to a different aperture of the guide. Moreover, the cable feedthrough 1 is flexible with respect to how many layers of sealing bodies that can be stacked above each other.

### Alternative embodiments

In addition to the above embodiments, further embodiments will be described below.

It is now referred to fig. 7a - 7f, where different embodiments of the cutout 12 are shown. These embodiments may also be relevant for the cutouts 22, 32, 32. It should be noted that fig. 7a - 7f shows the shape of the object being cut away from a rectangular prism to form the sealing body 10.

In fig. 7a, 7b and 7c, the cutouts are V-shaped. Fig. 7a shows the cutout as a half cone, fig. 7b shows the cutout as a triangular prism, while fig. 7c shows a cutout as a triangular pyramid.

In fig. 7d, 7e and 7f, the cutouts are U-shaped alternatives to the V-shaped cutouts of fig. 7a, 7b and 7c.

It is now referred to fig. 8a. Here, the cutout is V-shaped also in a plane parallel to the sealing plane SP, i.e. corresponding to the cutout shown in fig. 7c. The angle α1 from fig. 2 is indicated in fig. 8a. In addition, an angle β1 is indicating the shape of the V in the plane perpendicular to the sealing plane SP. The angle β1 may be ca 30° - 60°. It is also shown an apex or a narrow end 12c being distal relative to the cable axis LCA and a wider end 12d being proximal relative to the cable axis LCA.

It is now referred to fig. 8b. Here, the cutout is U-shaped in a plane parallel to the sealing plane SP.

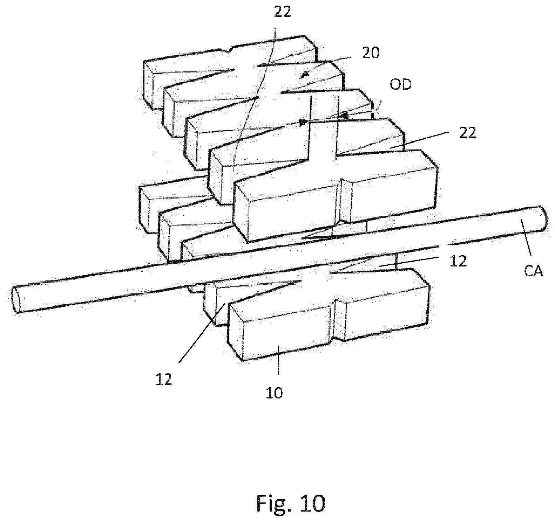

It is now referred to fig. 10. Here, each compressible sealing body 10, 20 comprises V-shaped or U-shaped cutouts on both the first side S1 and the second side S2 of the sealing plane SP.

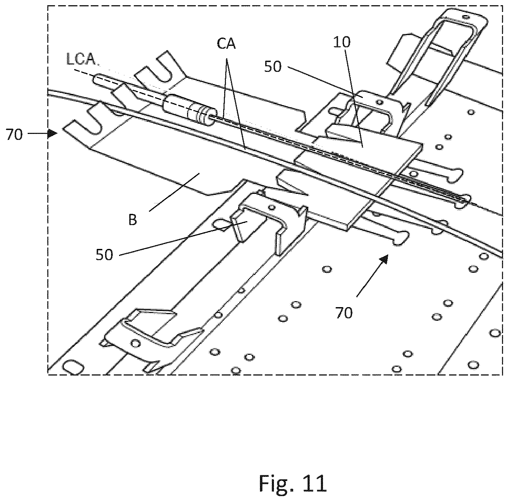

It is now referred to fig. 11. Here it is shown that the base B may comprise a strain relief 70 protruding in the cable axis LCA away from the sealing plane SP. The cable may be secured to the strain relief 70 by means of strips. In this way, the cable CA is held in the cable axis LCA during assembly and compression of the cable feedthrough 1. Also the compression device 60 and/or the separation element 65 may comprise such a strain relief 70.

## Claims

1. Cable feedthrough (1) for guiding a cable (CA) from a first side (S1) of a sealing plane (SP) to a second side (S2) of the sealing plane (SP), wherein the cable feedthrough (1) comprises:
- a first compressible sealing body (10) extending on both sides (S1, S2) of the sealing plane (SP);
- a second compressible sealing body (20) extending on both sides (S1, S2) of the sealing plane (SP) and provided abutting the first compressible sealing body (10);
- a compressing device (60) for compressing the first compressible sealing body (10) and the second compressible sealing body (20) towards each other;
wherein the first compressible sealing body (10) comprises a first V-shaped or U-shaped cutout (12) on the first side (S1) of the sealing plane (SP);
wherein the second compressible sealing body (20) comprises a second V-shaped or U-shaped cutout (22) on the second side (S2) of the sealing plane (SP);
wherein the first cutout (12) and the second cutout (22) are defining a cable axis (LCA) for the cable (CA).

2. Cable feedthrough (1) according to claim 1, wherein the cable axis (LCA) is substantially perpendicular to the sealing plane (SP).

3. Cable feedthrough (1) according to claim 1 or 2, wherein a narrow end (12a) of the first cutout (12) is provided at a distance (OD) from a narrow end (22a) of the second cutout (22).

4. Cable feedthrough (1) according to any one of the above claims, wherein the V-shape or U-shape of the cutouts (12, 22) are defined as the shape of the cutouts in a plane substantially perpendicular to the sealing plane (SP).

5. Cable feedthrough (1) according to any one of the above claims, wherein the V-shape or U-shape cutouts (12, 22) are V-shaped or U-shaped also in a plane parallel to the sealing plane (SP).

6. Cable feedthrough (1) according to any one of the above claims, wherein the cable feedthrough (1) comprises a guide (50) for guiding the bodies (10, 20) during compression.

7. Cable feedthrough (1) according to claim 6, wherein the first compressible sealing body (10) comprises a first groove (14) engaged with the guide (50) and wherein the second compressible sealing body (20) comprises a second groove (24) engaged with the guide (50).

8. Cable feedthrough (1) according to claim 6 or 7, wherein the compressing device (60) comprises a fastener (62) adjustably connected to the guide (50).

9. Cable feedthrough (1) according to any one of the above claims, wherein each compressible sealing body (10, 20) comprises V-shaped or U-shaped cutouts on both the first side (S1) and the second side (S2) of the sealing plane (SP).

10. Cable feedthrough (1) according to any one of the above claims, wherein the cable feedthrough (1) comprises a strain relief (70) protruding in the cable axis (LCA) away from the sealing plane (SP).

11. Cable feedthrough (1) according to any one of the above claims, wherein the cable feedthrough (1) comprises:
- a third compressible sealing body (30) extending on both sides (S1, S2) of the sealing plane (SP) and abutting the second compressible sealing body (20);
- a fourth compressible sealing body (40) extending on both sides (S1, S2) of the sealing plane (SP) and abutting the third compressible sealing body (30);
wherein the third compressible sealing body (30) comprises a third V-shaped or U-shaped cutout (32) provided on either the first side (S1) or the second side (S2); wherein the fourth compressible sealing body (40) comprises a fourth V-shaped or U-shaped cutout (42) on the opposite side of the third cutout (32);
wherein the third cutout (32) and the fourth cutout (42) are defining a further cable axis (LCA2) for a further cable (CA2);
wherein the third compressible sealing body (30) and the forth compressible sealing body (40) are compressed towards each other by means of the compressing device (60).

12. Cable feedthrough (1) according to claim 11, wherein the cable feedthrough (1) comprises:
- a separation element (65) provided between the second compressible sealing body (20) and the third compressible sealing body (30).

13. Method for guiding a cable (CA) from a first side (S1) of a sealing plane (SP) to a second side (S2) of the sealing plane (SP), comprising the steps of:
- providing a first compressible sealing body (10) on both sides (S1, S2) of the sealing plane (SP), wherein the first compressible sealing body (10) comprises a first V-shaped or U-shaped cutout (12) on the first side (S1) of the sealing plane (SP);
- providing a second compressible sealing body (20) on both sides (S1, S2) of the sealing plane (SP); wherein the second compressible sealing body (20) comprises a second V-shaped or U-shaped cutout (22) on the second side (S2) of the sealing plane (SP);
- placing the cable (CA) between the first compressible sealing body (10) and the second compressible sealing body (20);
- aligning the cable (CA) with the first and second cutouts (12, 22);
- compressing the first compressible sealing body (10) and the second compressible sealing body (20) towards each other.

14. Method according to claim 13, wherein the method further comprises the step of:
- securing the cable (CA) to a strain relief (70).

15. Method according to claim 13, wherein the method further comprises the step of:
- applying a sealing agent to the outside of the cable (CA) being in contact with the first compressible sealing body (10) and the second compressible sealing body (20).
